(19) Europäisches Patentamt
European Patent Office
Office européen des brevets

(11) **EP 3 005 425 B1**

(12) **FASCICULE DE BREVET EUROPEEN**

(45) Date de publication et mention de la délivrance du brevet:
**16.01.2019 Bulletin 2019/03**

(51) Int Cl.:
*H01L 31/072* (2012.01)    *H01L 31/0749* (2012.01)
*H01L 31/18* (2006.01)

(21) Numéro de dépôt: **14729449.0**

(86) Numéro de dépôt international:
**PCT/IB2014/061659**

(22) Date de dépôt: **23.05.2014**

(87) Numéro de publication internationale:
**WO 2014/188386 (27.11.2014 Gazette 2014/48)**

(54) **PROCÉDÉ DE RÉALISATION DE LA JONCTION P-N D'UNE CELLULE PHOTOVOLTAÏQUE EN COUCHES MINCES ET PROCÉDÉ D'OBTENTION CORRESPONDANT D'UNE CELLULE PHOTOVOLTAÏQUE**

VERFAHREN ZUR HERSTELLUNG DES P-N-ÜBERGANGS EINER FOTOVOLTAISCHEN DÜNNSCHICHTZELLE UND ZUGEHÖRIGES VERFAHREN ZUR HERSTELLUNG EINER FOTOVOLTAISCHEN ZELLE

METHOD FOR PRODUCING THE P-N JUNCTION OF A THIN-FILM PHOTOVOLTAIC CELL AND CORRESPONDING METHOD FOR PRODUCING A PHOTOVOLTAIC CELL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.05.2013 FR 1354696**

(43) Date de publication de la demande:
**13.04.2016 Bulletin 2016/15**

(73) Titulaire: **Commissariat à l'Énergie Atomique et aux Énergies Alternatives**
**75015 Paris (FR)**

(72) Inventeurs:
• **ALTAMURA, Giovanni**
  **75014 Paris (FR)**
• **GRENET, Louis**
  **38000 Grenoble (FR)**
• **PERRAUD, Simon**
  **83150 Bandol (FR)**
• **ROUX, Frédéric**
  **38120 Saint-egreve (FR)**

(74) Mandataire: **Gevers & Orès**
  **41 avenue de Friedland**
  **75008 Paris (FR)**

(56) Documents cités:
**EP-A2- 0 837 511**    **EP-A2- 2 375 453**
**US-A- 5 948 176**    **US-A1- 2011 056 541**
**US-A1- 2012 024 366**    **US-B1- 6 259 016**

**Description**

La présente invention concerne le domaine de l'énergie solaire photovoltaïque et plus particulièrement les cellules photovoltaïques en couches minces.

Dans le cadre de la présente demande, une « *couche mince* » sera une couche présentant une épaisseur inférieure à 5 $\mu$m, voire inférieure à 3 $\mu$m.

Ces cellules photovoltaïques permettent de convertir directement la lumière du soleil en électricité en utilisant les propriétés électroniques de matériaux appropriés.

En pratique, la fabrication d'une cellule photovoltaïque implique la formation d'une jonction p-n entre un semi-conducteur de type p, dans lequel la lumière est absorbée, et un semi-conducteur de type n.

A l'interface entre les semi-conducteurs de type p et de type n, un champ électrique se forme, permettant la séparation de charges qui est à la base de la conversion photovoltaïque.

Ainsi, une cellule photovoltaïque en couches minces comprend en général un substrat pour supporter l'empilement de couches, cet empilement comprenant une couche métallique formant l'électrode inférieure, une couche absorbante, de type n ou p, pour générer des charges lors de l'absorption de lumière avec des pertes de transmission et de réflexion minimales, une couche tampon, de type p ou n (la couche tampon étant du type opposé à celui de la couche absorbante) pour créer la jonction avec la couche absorbante avec un minimum de perte d'absorption et une électrode transparente conductrice pour amener le courant à un circuit extérieur.

Chaque matériau présente des propriétés physiques et chimiques particulières qui ont une influence sur la performance globale de la cellule photovoltaïque.

De plus, tout défaut à l'interface entre la couche tampon et la couche absorbante constitue une zone où les charges électriques sont susceptibles de se recombiner. De ce fait, il est essentiel de pouvoir contrôler la formation de la jonction p-n au sein d'une cellule photovoltaïque, pour éviter la formation de défauts.

Il convient de noter que les cellules solaires en couches minces présentent des avantages par rapport aux cellules solaires réalisées en silicium cristallin. Ceci résulte notamment du fait qu'elles nécessitent moins de matériau car leur couche absorbante présente un meilleur coefficient d'absorption optique.

La couche absorbante d'une cellule photovoltaïque en couches minces peut notamment être réalisée en un matériau du type CIGS, de formule générale $Cu(In,Ga)(S,Se)_2$, CdTe ou encore CZTS, de formule générale $Cu_2ZnSn(S,Se)_4$.

Ces matériaux conduisent à différents rendements de conversion énergétique, ce rendement étant défini comme le pourcentage de l'énergie solaire à laquelle la cellule est exposée qui est convertie en énergie électrique.

Ainsi, un matériau du type CIGS présente aujourd'hui le meilleur rendement de conversion énergétique puisque ce dernier est d'environ 20%.

Le rendement de conversion énergétique est de l'ordre de 1 5% pour un matériau du type CdTe et de l'ordre de 10% pour un matériau du type CZTS.

De façon générale, la jonction p-n est réalisée en formant tout d'abord la couche absorbante en un matériau du type CIGS, CZTS ou CdTe et, dans un deuxième temps, la couche tampon.

Lors de la formation de la couche tampon, la surface de la couche absorbante est susceptible d'être contaminée par de l'oxygène. C'est en particulier le cas lorsque la couche tampon est formée par une technique de dépôt en bain chimique (Chemical Bath Déposition ou CBD dans la terminologie anglaise).

Cette oxydation conduit à la formation de défauts.

Ainsi, il a pu être démontré qu'avec un matériau du type CIGS et CZTS, la période de temps séparant la formation de la couche absorbante et le dépôt de la couche tampon joue un rôle majeur dans les performances finales d'une cellule photovoltaïque,

De façon à diminuer les risques de contamination de la jonction p-n par oxydation, deux solutions ont déjà été proposées dans l'état de la technique : l'utilisation d'une structure superstrat et l'utilisation d'un procédé sous vide.

Une cellule solaire peut présenter une structure du type substrat ou superstrat.

Dans une structure du type substrat, la fabrication de la cellule solaire commence par la formation, sur un substrat, d'une couche métallique formant l'électrode inférieure sur laquelle est ensuite réalisée une couche absorbante, par exemple de type p. Cette couche absorbante peut notamment se présenter sous la forme d'un film mince en CIGS ou CZTS.

La couche tampon, en un matériau semi-conducteur de type n, est ensuite déposée sur la couche absorbante, La cellule est terminée par le dépôt d'une électrode transparente conductrice.

Le même empilement de couches peut aussi être obtenu en déposant les couches dans le sens inverse, de façon à obtenir une structure du type superstrat.

Ainsi, la fabrication de la cellule solaire de type superstrat commence par le dépôt d'une électrode transparente conductrice sur un substrat transparent. Une couche tampon, de type n, est ensuite déposée sur cette électrode transparente conductrice, une couche absorbante de type p étant alors formée sur la couche tampon.

La fabrication de la cellule solaire se termine par la formation d'une couche métallique formant une électrode arrière.

Ces deux structures présentent des différences importantes en ce qui concerne le choix des matériaux qui peuvent être utilisés et des procédés qui peuvent être mis en oeuvre.

En particulier, l'avantage majeur de la structure du type superstrat est qu'aucune oxydation de la couche absorbante ne peut avoir lieu au niveau l'interface avec la couche tampon.

Cette configuration présente cependant un inconvénient.

En effet, la formation de la couche absorbante s'effectue à des températures relativement élevées. Ceci peut conduire à une diffusion chimique depuis la couche tampon dans la couche absorbante.

Ainsi, lorsque la couche tampon est réalisée en CdS, des températures supérieures à 450°C, nécessaires à la formation de la couche absorbante, conduisent à la diffusion de Cd dans la couche absorbante.

C'est pourquoi, à ce jour, le rendement de conversion énergétique d'une cellule solaire présentant une structure de type superstrat comprenant une jonction p-n entre une couche absorbante en CIGS et une couche tampon en CdS est limité à environ 7%.

Les cellules solaires présentant une structure du type superstrat avec une couche tampon en ZnS ou ZnO présente de meilleurs rendements, par exemple de l'ordre de 11% dans le cas de ZnO. Cependant, ces matériaux conduisent néanmoins à une diffusion chimique importante depuis la couche tampon dans la couche absorbante.

Par ailleurs, quel que soit le type de structure retenu, la jonction p-n est toujours formée en deux étapes, la couche absorbante et la couche tampon étant réalisées indépendamment l'une de l'autre.

On peut citer à cet égard le document EP-2 339 641.

Il a également été proposé de réaliser la jonction p-n d'une cellule solaire en mettant en oeuvre un procédé sous vide.

Ce procédé présente l'avantage de pouvoir être facilement mis en oeuvre à l'échelle industrielle car il peut être intégré dans un système en ligne complet conduisant à des volumes de production importants.

Surtout, ce procédé permet d'éviter l'oxydation de la surface de la couche absorbante.

Cependant, avec un tel procédé, la jonction p-n est toujours formée en deux étapes successives.

Il a également été envisagé de déposer la couche tampon par une technique de dépôt physique en phase vapeur (Physical Vapor Déposition ou PVD dans la terminologie anglaise), pour éviter la contamination de la couche absorbante par de l'oxygène.

Cependant, il a été montré qu'au moins pour les cellules solaires comportant une couche absorbante en CIGS et une couche tampon en CdS, le rendement de conversion énergétique obtenu était alors significativement inférieur à celui obtenu lorsque la couche tampon était déposée par une technique de dépôt en bain chimique (Chemical Bath Déposition ou CBD dans la terminologie anglaise).

On peut, en effet, constater une différence de l'ordre de 7%, correspondant à un rendement de 20% avec une couche de CdS obtenue par une technique CBD et à un rendement de 13% avec une couche de CdS obtenue par une technique PVD.

Ceci est notamment du au fait que la technique CBD endommage moins la surface de la couche absorbante que la technique PVD. Ce constat reste valable pour d'autres matériaux constitutifs de la couche tampon.

Enfin, pour des matériaux formant la couche absorbante du type CIGS, CZTS et CdTe, les meilleures performances sont obtenues lorsque la jonction p-n est formée avec une couche tampon réalisée en un matériau du type CdS, déposée par une technique de dépôt en bain chimique.

Cependant, le cadmium est un élément toxique.

Le document EP837511 divulgue la disposition d'un matériau de plus garnde résistance que la chalcopyrite entre le CIGS et la couche tampon du dispositif photovoltaïque.

L'invention a pour objet de pallier les inconvénients des procédés connus en proposant un procédé de réalisation d'une jonction p-n dans une cellule photovoltaïque en couches minces qui permette d'éviter la formation de défauts au niveau de cette jonction résultant notamment d'une oxydation, qui soit d'une mise en oeuvre simplifiée et qui permette d'éviter l'utilisation de cadmium.

Le procédé selon l'invention est défini dans la revendication 1.

Ce procédé permet d'éviter à la fois une oxydation et une diffusion chimique à l'interface entre la couche absorbante et la couche tampon tout en réalisant la couche photovoltaïque et la couche tampon lors de la même étape de recuit. Ceci conduit donc à une jonction p-n de très bonne qualité avec un procédé dont la mise en oeuvre est simplifiée.

Les précurseurs du matériau photovoltaïque de type p ou n comprennent des précurseurs métalliques de Cu, Zn, Sn ou de Cu, Ga et In.

Dans une première variante, une couche de Se et/ou S est déposée sur la couche de précurseurs d'un matériau photovoltaïque de type p ou n, avant le dépôt de la couche barrière.

Dans une deuxième variante, les précurseurs d'un matériau photovoltaïque comprennent également des composés séléniés et/ou soufrés desdits précurseurs métalliques.

De façon préférée, le précurseur d'un matériau semi-conducteur de type n ou p est de l'indium et conduit à la formation d'une couche tampon en $In_2S_3$.

Ceci permet d'éviter l'utilisation de cadmium qui est un élément toxique.

Lors de l'étape de recuit, le soufre et le sélénium sont avantageusement apportés sous forme gazeuse.

L'étape de recuit est réalisée à une température comprise entre 400 et 650°C, avec des rampes de montée en température comprises entre 1°C/s et 15°C/s.

Par ailleurs, la couche barrière est formée d'un nitrure ou d'un oxyde. Elle est avantageusement une couche de $Si_3N_4$, $SiO_2$ ou $TiO_2$.

L'invention concerne également un procédé de réalisation d'une cellule photovoltaïque en couches minces.

Ce procédé comprend les étapes suivantes :

- la réalisation d'une électrode en face arrière sur un substrat,
- la mise en oeuvre du procédé de réalisation d'une jonction p-n selon l'invention et
- la réalisation d'une électrode en face avant, transparente et conductrice.

De façon avantageuse, l'électrode en face arrière est une couche de molybdène.

De façon préférée, une couche de ZnO intrinsèque est déposée après la mise en oeuvre du procédé de réalisation d'une jonction pn selon l'invention et avant la réalisation de l'électrode transparente conductrice.

Cette électrode transparente et conductrice est avantageusement réalisée en ZnO dopé Al.

L'invention concerne un procédé de réalisation d' une cellule photovoltaïque en couches minces comprenant successivement une électrode en face arrière, une couche absorbante en un matériau photovoltaïque de type p ou n, une couche barrière, une couche tampon de type n ou p et une électrode en face avant, transparente et conductrice, avec une jonction p-n à l'interface entre la couche absorbante et la couche tampon.

De façon avantageuse, la couche barrière est formée d'un nitrure ou d'un oxyde et la couche tampon est réalisée en $In_2(S, Se)_3$ ou encore en Zn(O, S) ou Zn(O, Se).

L'invention sera mieux comprise et d'autres buts, avantages et caractéristiques de celle-ci apparaîtront plus clairement à la lecture de la description qui suit et qui est fait au regard des dessins annexés, sur lesquels :

- la figure 1 est une vue en coupe d'un empilement de couches obtenu après l'étape de dépôt du procédé selon l'invention,
- la figure 2 est une vue en coupe d'un empilement de couches obtenu après l'étape de recuit du procédé selon l'invention,
- la figure 3 est un graphe donnant la densité de courant en fonction de la tension pour une cellule solaire obtenue par le procédé selon l'invention, et
- la figure 4 est un graphe donnant la densité de courant en fonction de la tension pour une cellule solaire similaire à celle faisant l'objet du graphe de la figure 3 mais obtenue par un procédé classique.

Les éléments communs aux différentes figures seront désignés par les mêmes références.

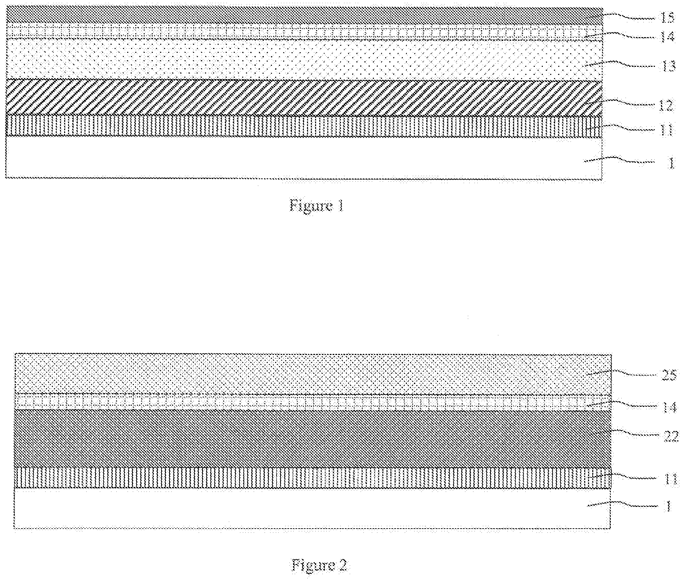

En référence à la figure 1, le procédé de réalisation d'une cellule photovoltaïque selon l'invention consiste tout d'abord à déposer, sur un substrat 1, une couche métallique 11 formant une électrode de face arrière pour la cellule photovoltaïque qui sera obtenue par le procédé selon l'invention.

Le substrat 1 peut être réalisé en divers matériaux. classiquement en verre, en plastique ou en métal. En général, ce substrat est réalisé en verre sodocalcique et présente une épaisseur comprise entre 1 et quelques millimètres d'épaisseur. On peut également envisager des substrats flexibles, métalliques ou plastiques.

La couche 11 est par exemple réalisée en molybdène et son épaisseur est comprise entre 100 nm et 2 $\mu$m et elle est notamment égale à 500 nm.

Le dépôt de la couche de molybdène peut notamment être réalisé par pulvérisation cathodique.

Sur la couche 11, sont ensuite déposés, sous la forme d'une couche 12, les précurseurs qui conduiront à la formation de la couche photovoltaïque.

Il s'agit de précurseurs métalliques de Cu, Zn, Sn et éventuellement d'au moins un élément pris parmi Se et S.

A titre d'exemple, les ratios des éléments Cu, Zn et Sn sont classiquement choisis de telle sorte que

$$0.75 \leq Cu/(Zn+Sn) \leq 0.95 \text{ et } 1.05 \leq Zn/Sn \leq 1.35.$$

Cette couche 12 peut comporter essentiellement des précurseurs métalliques, Dans ce cas, le soufre et/ou le sélénium sont alors apportés sous forme gazeuse,

Ils peuvent également être apportés sous la forme d'une couche 13 déposée sur la couche de précurseurs métalliques.

Par ailleurs, la couche 12 peut être une couche de précurseurs métalliques et/ou de leurs composés séléniés et/ou soufrés correspondants. Ainsi, la couche 12 peut être une couche de Cu, Zn et Sn et/ou de leurs composés séléniés ou soufrés tels que CuSe, CuS, ZnSe, ZnS, SnSe, SnS, ou n'importe quelle combinaison de ces composés. Dans ce cas, il n'est pas nécessaire de prévoir une couche 13 constituée de soufre et/ou de sélénium.

De façon générale, dans le cadre de l'invention, est préféré l'apport de sélénium et/ou de soufre sous la forme d'un dépôt dans l'empilement En effet, il est alors plus facile de contrôler la composition finale de la couche photovoltaïque qu'avec un apport sous forme gazeuse.

Ainsi, à titre d'exemple, la couche 12 peut comporter trois couches successives, une couche en ZnS, une couche en cuivre et une couche en étain, l'ordre de ces couches pouvant être modifié.

L'épaisseur de la couche de ZnS peut alors être d'environ 350 nm, celle de la couche de cuivre d'environ 120 nm et celle de la couche d'étain d'environ 160 nm.

Dans ce cas, la couche 13 peut être une couche de sélénium et présenter une épaisseur d'environ 2 $\mu$m.

De nombreux procédés de dépôt adaptés à la formation de couches minces peuvent être utilisés pour réaliser les couches 12 et 13.

Il peut s'agir de procédés sous vide, tels que l'évaporation ou la pulvérisation cathodique ou de procédés mis en oeuvre à pression atmosphérique, tels que l'électrodépôt, la sérigraphie, le doctor-blading, le jet d'encre ou le slit-coating.

Directement sur la couche de précurseurs 12 ou sur la couche 13 de S et/ou Se lorsqu'elle est prévue, est ensuite déposée une couche barrière 14. Cette couche est continue.

Comme cela sera expliqué ultérieurement, cette couche barrière permet d'éviter la diffusion chimique de composants et une oxydation.

Cette couche barrière est formée d'un composé à base de nitrure ou d'oxyde. Elle peut notamment être réalisée en $Si_3N_4$, $SiO_2$ ou $TiO_2$. Son épaisseur est de quelques nanomètres et par exemple égale à 4 nm.

Enfin, sur la couche 14, est ensuite déposée une couche 15 d'au moins un précurseur d'un matériau semiconducteur dont le dopage sera de type n si le matériau photovoltaïque obtenu à partir des couches 12 et 13 est de type p et inversement

Ainsi, cette couche 15 est réalisée en indium ou en zinc et son épaisseur sera de quelques dizaines de nanomètres et par exemple d'environ 30 nm.

Une fois que cet empilement est réalisé, il est soumis à une étape de recuit, réalisée avec un apport de S et/ou Se.

Le chalcogène S ou Se peut être alors apporté sous la forme de gaz élémentaire ou sous la forme de gaz de type $H_2S$ ou $H_2Se$.

Cette étape de recuit conduit à la formation d'une couche absorbante 22 en matériau photovoltaïque et d'une couche tampon 25.

Cette étape de recuit ne modifie pas la couche barrière 14.

Cette étape de recuit, classiquement dénommée recuit de sélénisation/sulfurisation, s'effectue à haute température.

Cette étape de recuit peut notamment être réalisée en utilisant une rampe de montée en température comprise entre 1°C/s et 15°C/s de façon à obtenir une température comprise entre 500 et 650°C et par exemple égale à 550°C.

La durée du palier à haute température peut être comprise entre 30 secondes et 30 minutes, et elle est avantageusement égale à 3 minutes.

Cette température permet la cristallisation des précurseurs métalliques en CIGS ou CZTS, de façon à obtenir la couche 22.

Cette étape de recuit permet également de transformer le ou les précurseurs présents dans la couche 15 en un matériau formant la couche tampon 25.

Avec les exemples de matériaux donnés précédemment, la couche 25 est alors formée en $In_2(S, Se)_3$ ou encore en $Zn(O, S)$ ou $Zn(O, Se)$.

Par ailleurs, avec les valeurs d'épaisseur des différentes couches données dans l'exemple précédent, l'étape de recuit conduit à une couche 22 en CZT(S, Se) d'une épaisseur de 1,2 $\mu$m, tandis que la couche 25 en $In_2(S, Se)_3$ est d'environ 50 nm.

Lors de cette étape de recuit, la couche barrière 14 empêche la diffusion des composants présents dans la couche 12, notamment de l'indium ou du zinc, dans le matériau photovoltaïque de la couche 22. Elle permet donc d'éviter une oxydation entre la couche absorbante et la couche tampon lors du recuit.

Il convient cependant de noter que cette étape de recuit peut s'accompagner de la formation d'une couche de $Mo(S, Se)_2$ à l'interface entre la couche 11 en molybdène et la couche 22 en matériau photovoltaïque.

L'épaisseur de la couche de $Mo(S, Se)_2$ dépend de nombreux paramètres, notamment de la quantité de S/Se apportée. On peut l'estimer comprise entre 5 et 100 nm. Il est connu que sa présence favorise un contact de type ohmique à l'interface avec la couche absorbante 22, notamment en CIGS.

Après cette étape de recuit, la formation d'une cellule photovoltaïque nécessite encore le dépôt d'une électrode transparente et conductrice de face avant (non représentée sur les figures).

Cette électrode en face avant est réalisée en un matériau transparent et conducteur.

Elle peut notamment être constituée en ZnO dopé Al.

L'épaisseur de cette couche est typiquement comprise entre 100 et 800 nm et de préférence égale à environ 500 nm.

Le matériau formant cette électrode transparente et conductrice peut notamment être déposé par pulvérisation cathodique,

Il convient encore de noter qu'avant le dépôt de cette couche formant l'électrode de face avant, peut être déposée, sur la couche tampon 25, une couche d'un matériau transparent dans le spectre solaire et fortement résistive.

Cette couche est typiquement réalisée en ZnO intrinsèque et peut présenter une épaisseur de quelques dizaines de nanométres, et notamment de 50 nm pour la cellule solaire donnée à titre d'exemple précédemment.

Le matériau constitutif de cette couche peut typiquement être déposé par pulvérisation cathodique.

Cette couche est facultative et elle peut être omise sans entraîner une dégradation significative des performances électriques de la cellule photovoltaïque.

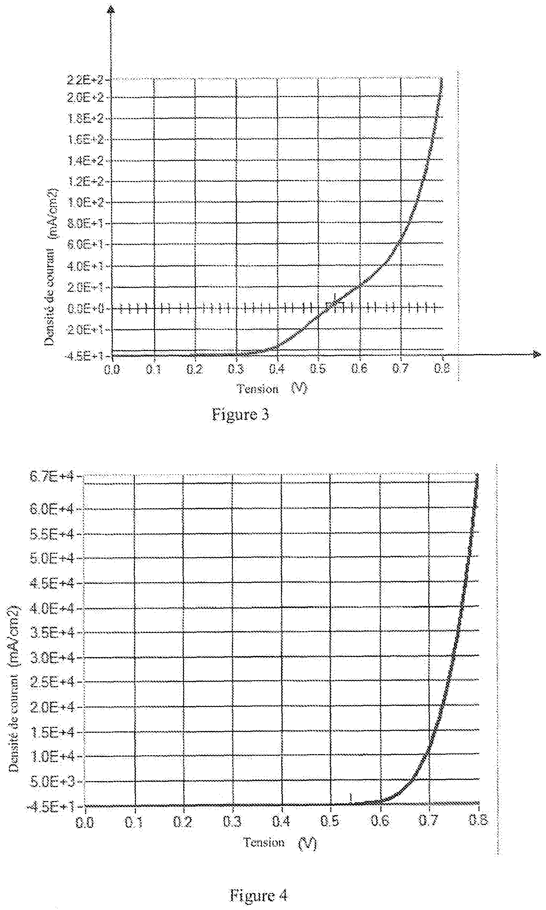

Il est maintenant fait référence aux figures 3 et 4 qui sont des graphes donnant la densité de courant (en $mA/cm^2$) en fonction de la tension (en V).

Ces graphes résultent de simulations réalisées avec le logiciel SCAPS de la cellule solaire donnée à titre d'exemple précédemment, pour la figure 3 et d'une cellule similaire mais obtenue par un procédé classique, pour la figure 4.

Ces graphes permettent d'illustrer le fonctionnement de chacune de ces cellules.

Ainsi, pour la figure 3, il s'agit d'une cellule solaire dont l'électrode inférieure ou de face arrière est une couche de molybdène dont l'épaisseur est de 500 nm, une couche absorbante en CZT (S, Se) dont l'épaisseur est d'environ 1,2 $\mu$m, une couche barrière en $Si_3N_4$ dont l'épaisseur est d'environ 4 nm, une couche tampon en $In_2(S, Se)_3$ d'épaisseur d'environ 50 nm, une couche en ZnO dont l'épaisseur est d'environ 50 nm et enfin, une couche en ZnO dopé Al dont l'épaisseur est d'environ 500 nm.

Cette cellule solaire est obtenue avec le procédé selon l'invention.

Pour la figure 4, la cellule solaire comporte les mêmes couches, sauf en ce qui concerne la couche barrière qui est absente.

La comparaison des figures 3 et 4 montre que cette cellule solaire selon l'invention fonctionne de la même façon qu'une cellule solaire similaire, obtenue par un procédé classique et ne comportant pas une couche barrière.

Ainsi, la figure 3 montre qu'il est possible d'obtenir une séparation des charges même si une couche barrière est prévue au niveau de la jonction pn. En pratique, cette séparation des charges est possible car les électrons présents dans la bande de conduction sont capables de dépasser la couche barrière par effet tunnel.

Il convient encore de noter qu'avec la cellule obtenue par le procédé selon l'invention et une cellule similaire obtenue selon un procédé classique et sans couche barrière, les deux grandeurs suivantes restent inchangées : la tension de circuit ouvert Voc (en V) et la densité de courant de court-circuit Jsc (en $mA/cm^2$). En effet, pour Voc, on mesure une valeur de 0,5263 V pour la cellule de la figure 3 et une valeur de 0,5228 V pour la cellule de la figure 4. Par ailleurs, pour Jsc, on mesure une valeur de 45,2830 $mA/cm^2$ pour la cellule de la figure 3 et une valeur de 45,3024 $mA/cm^2$ pour la cellule de la figure 4.

En ce qui concerne le facteur de forme FF et le rendement de conversion énergétique, les valeurs correspondantes pour la cellule de la figure 3 obtenue par le procédé selon l'invention sont de 63,27 % et de 15,08 %. Ces valeurs sont respectivement de 78,46 % et de 18,58 % pour la cellule de la figure 4.

Ainsi, le rendement de conversion énergétique de la cellule solaire de la figure 3 est supérieur à celui obtenu pour des cellules solaires présentant une structure du type superstrat ou dont la jonction p-n est obtenue par un procédé sous vide, toutes ces cellules évitant l'oxydation de la couche absorbante.

Par ailleurs, par rapport à tous les procédés connus, et notamment celui utilisé pour réaliser la cellule solaire de la figure 4, le procédé selon l'invention permet de réaliser en une seule étape de recuit à la fois la couche absorbante et la couche tampon d'une cellule solaire.

Ceci montre que le procédé selon l'invention permet bien d'obtenir une cellule solaire fonctionnant de manière satisfaisante, tout en évitant les risques d'oxydation et de diffusion chimique à l'interface entre la couche absorbante et la couche tampon et l'utilisation de cadmium et en étant d'une mise en oeuvre simplifiée.

Les signes de référence insérés après les caractéristiques techniques figurant dans les revendications ont pour seul but de faciliter la compréhension de ces dernières et ne sauraient en limiter la portée.

## Revendications

1. Procédé de réalisation d'une jonction pn dans une cellule photovoltaïque en couches minces, ledit procédé comprenant une étape de dépôt destinée à former un empilement de couches lors de laquelle sont réalisées successivement: une couche (12) de précurseurs d'un matériau photovoltaïque de type p ou n lesdits précurseurs comprenant des précurseurs métalliques de Cu, Zn et Sn ou de Cu, Ga et In, ainsi que du sélénium et/ou du soufre, une couche barrière (14) et une couche (15) de précurseur d'un matériau semi-conducteur de type n ou p, constituée d'indium ou de zinc, ledit procédé étant **caractérisé en ce que** l'étape de dépôt est suivie d'une seule étape de recuit réalisée avec un apport de S et/ou Se, cette étape de recuit conduisant à la formation d'une couche absorbante (22) de type p ou n à partir de la couche (12) de précurseurs du matériau photovoltaïque et d'une couche tampon (25) de type n ou p, à partir de la couche (15) d'indium ou de zinc, ainsi que d'une jonction p-n à l'interface entre lesdites couches, la couche barrière empêchant une diffusion chimique et une oxydation à l'interface entre la couche absorbante (22) et la couche tampon (25) lors de cette étape de recuit, la couche barrière (14) étant adaptée pour permettre le passage de porteurs de charge par effet tunnel, ladite étape de recuit étant réalisée à une température comprise entre 400°C et 650°C, avec des rampes de montée en température comprises entre 1°C/s et 15°C/s.

2. Procédé selon la revendication 1, dans lequel une couche (13) de Se et/ou S est déposée sur la couche (12) de précurseurs d'un matériau photovoltaïque de type p ou n, avant le dépôt de la couche barrière (14).

3. Procédé selon la revendication 1, dans lequel les précurseurs d'un matériau photovoltaïque comprennent également des composés séléniés et/ou soufrés desdits précurseurs métalliques.

4. Procédé selon l'une des revendications 1 à 3, dans lequel le précurseur d'un matériau semi-conducteur de type n ou p est de l'indium.

5. Procédé selon l'une des revendications 1 à 4, dans lequel, lors de l'étape de recuit, le soufre et le sélénium sont apportés sous forme gazeuse.

6. Procédé selon l'une des revendications 1 à 5, dans lequel la couche barrière (14) est formée d'un nitrure ou d'un oxyde d'une épaisseur de quelques nanomètres.

7. Procédé de réalisation d'une cellule photovoltaïque en couches minces comprenant les étapes suivantes :

   - la réalisation d'une électrode en face arrière (11) sur un substrat (1),
   - la mise en oeuvre du procédé selon l'une des revendications 1 à 6 et
   - la réalisation d'une électrode en face avant, transparente et conductrice.

8. Procédé selon la revendication 7, dans lequel l'électrode en face arrière (11) est une couche de molybdène, tandis que l'électrode en face avant est une couche de ZnO dopé Al.

9. Procédé selon l'une des revendications 7 ou 8, dans lequel une couche de ZnO intrinsèque est déposée après la mise en oeuvre du procédé selon l'une des revendications 1 à 6 et avant la réalisation de l'électrode en face avant.

## Patentansprüche

1. Verfahren zur Herstellung eines pn-Übergangs einer photovoltaischen Dünnschichtzelle, wobei das Verfahren einen Schritt des Auftragens umfasst, der dazu bestimmt ist, einen Stapel von Schichten zu bilden, in welchem sukzessiv Folgendes hergestellt wird: eine Vorläuferschicht (12) eines photovoltaischen Materials vom p- oder n-Typ, wobei die Vorläufer Cu-, Zn-, und Sn- oder Cu-, Ga- und In-Metallvorläufer sowie Selen und/oder Schwefel umfassen, eine Sperrschicht (14) und eine Vorläuferschicht (15) eines Halbleitermaterials vom n- oder p-Typ, die aus Indium oder Zink besteht, wobei das Verfahren **dadurch gekennzeichnet ist, dass** dem Schritt des Auftragens ein einziger Schritt des Glühens folgt, der mit einer S-und/oder Se-Zufuhr hergestellt wird, wobei der Schritt des Glühens zu der Bildung einer absorbierenden Schicht (22) vom p- oder n-Typ aus der Vorläuferschicht (12) des photovoltaischen Materials und einer Pufferschicht (25) vom n- oder p-Typ, aus der Indium- oder Zinkschicht (15) sowie einem pn-Übergang an der Grenzfläche zwischen den Schichten führt, wobei die Sperrschicht während dieses Schritts des Glühens eine chemische Diffusion und eine Oxidation an der Grenzfläche zwischen der absorbierenden Schicht (22) und der Pufferschicht (25) verhindert, wobei die Sperrschicht (14) angepasst ist, um die Tunnelung von Ladungsträgern zu ermöglichen, wobei der Schritt des Glühens bei einer Temperatur in einem Bereich zwischen 400 °C und 650 °C mit Rampen zur Temperaturerhöhung in einem Bereich zwischen 1 °C/s und 15 °C/s hergestellt wird.

2. Verfahren nach Anspruch 1, wobei eine Se- und/oder S-Schicht (13) auf die Vorläuferschicht (12) eines photovoltaischen Materials vom p- oder n-Typ vor dem Auftragen der Sperrschicht (14) aufgetragen wird.

3. Verfahren nach Anspruch 1, wobei die Vorläufer eines photovoltaischen Materials ebenfalls Selen- und/oder Schwefelverbindungen der Metallvorläufer umfassen.

4. Verfahren nach einem der Ansprüche 1 bis 3, wobei der Vorläufer eines Halbleitermaterials vom n- oder p-Typ Indium ist.

5. Verfahren nach einem der Ansprüche 1 bis 4, wobei während des Schritts des Glühens der Schwefel und das Selen in gasförmigem Zustand zugeführt werden.

6. Verfahren nach einem der Ansprüche 1 bis 5, wobei die Sperrschicht (14) aus einem Nitrid oder einem Oxyd mit einer Dicke von einigen Nanometern gebildet ist.

7. Verfahren zur Herstellung einer photovoltaischen Dünnschichtzelle, umfassend die folgenden Schritte:

- die Herstellung einer rückseitigen Elektrode (11) auf einem Substrat (1),
- die Durchführung des Verfahrens nach einem der Ansprüche 1 bis 6 und
- die Herstellung einer vorderseitigen, transparenten und leitenden Elektrode.

8. Verfahren nach Anspruch 7, wobei die rückseitige Elektrode (11) eine Molybdänschicht ist, wohingegen die vorderseitige Elektrode eine aus Al-dotiertem ZnO bestehende Schicht ist.

9. Verfahren nach einem der Ansprüche 7 oder 8, wobei eine aus intrinsischem ZnO bestehende Schicht nach der Durchführung des Verfahrens nach einem der Ansprüche 1 bis 6 und vor der Herstellung der vorderseitigen Elektrode aufgetragen wird.

**Claims**

1. Method for producing a p-n junction in a thin-film photovoltaic cell, said method comprising a deposition step intended to form a stack of layers, during which are successively produced:

a layer (12) of precursors of a photovoltaic material of the p-or n-type, said precursors comprising metal precursors of Cu, Zn, and Sn or of Cu, Ga and In, as well as selenium and/or sulphur,
a barrier layer (14) and a precursor layer (15) of a semiconductor material of the n- or p-type, constituted of indium or zinc,
said method being **characterised in that**
the deposition step is followed by a single annealing step performed with a supply of S and/or Se, this annealing step leading to the formation of an absorbent layer (22) of the p- or n-type from the layer (12) of precursors of a photovoltaic material and a buffer layer (25) of the n- or p- type, from the indium or zinc layer (15), as well as a p-n junction at the interface between said layers, the barrier layer preventing a chemical diffusion and an oxidation at the interface between the absorbent layer (22) and the buffer layer (25) during this annealing step, the barrier layer (14) being adapted to make it possible for the passage of charge carriers by tunnel effect, said annealing step being performed at a temperature of between 400 °C and 650 °C, with temperature increase ramp-rates of between 1 °C/s and 15 °C/s.

2. Method according to claim 1, wherein a layer (13) of Se and/or S is deposited on the layer (12) of precursors of a photovoltaic material of the n- or p-type, before the deposition of the barrier layer (14).

3. Method according to claim 1, wherein the precursors of a photovoltaic material also comprise selenium and/or sulphur compounds of said metal precursors.

**4.** Method according to one of claims 1 to 3, wherein the precursor of a semiconductor material of the n- or p-type is indium.

**5.** Method according to one of claims 1 to 4, wherein, during the annealing step, the sulphur and the selenium are supplied in a gaseous form.

**6.** Method according to one of claims 1 to 5, wherein the barrier layer (14) is formed by a nitride or an oxide with a thickness of a few nanometres.

**7.** Method for producing a thin-film photovoltaic cell comprising the following steps:

- the production of a rear-face electrode (11) on a substrate (1),
- the implementation of the method according to one of claims 1 to 6 and
- the implementation of a transparent and conductive front-face electrode.

**8.** Method according to claim 7, wherein the rear-face electrode (11) is a layer of molybdenum, while the front-face electrode is a layer of Al-doped ZnO.

**9.** Method according to one of claims 7 or 8, wherein an intrinsic layer of ZnO is deposited after the implementation of the method according to one of claims 1 to 6 and before the production of the front-face electrode.

Figure 1

Figure 2

Figure 3

Figure 4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2339641 A

- EP 837511 A